# EUROPEAN PATENT APPLICATION

(11) **EP 2 397 450 A2**
(43) Date of publication of application: **21.12.2011**
(21) Application number: 11169630.8
(22) Date of filing: 10.06.2011
(51) Int. Cl.: C03C 23/00, H01L 31/18, B23K 26/00

(54) **System and method for modifying a glass article**

(30) Priority: 18.06.2010 US 818717
(71) Applicant: PrimeStar Solar, Inc, Arvada, CO 80004 (US)
(72) Inventor: Murphy, Brian Robert, Evergreen, Colorado 80439 (US)
(74) Representative: Bedford, Grant Richard

(57) **Abstract**

A system (400) and method for modifying an article (401) to increase resistance to crack propagation are disclosed. The method includes providing a system (400), positioning one or more lasers (402), and directing a predetermined energy (404) to a topographical feature (406) on a surface (410) of an article (401).

## Description

The present disclosure is directed generally to a system and method for strengthening a substrate and an article including the strengthened substrate. More specifically, the present disclosure relates to a system and method for producing an article with increased resistance to crack propagation.

Generally, articles (for example, glass substrates) can fail by propagation of a crack from an edge or corner defect. Thus, edge or corner defects on articles can be undesirable. Removing the edge or the corner defects can improve the strength of the article by increasing resistance to crack propagation and, thus, failure.

Similarly, articles (for example, glass substrates) including debris can be undesirable by affecting properties of the surface. For example, debris may affect mechanical properties, such as by affecting optical properties of the article. Additionally or alternatively, debris may affect electrical properties, such as by causing shorting. Thus, debris on articles can be undesirable.

Debris or defects on glass substrates within a photovoltaic cell can be especially undesirable. The debris or defects can alter the optics, affect adhesion of coatings, and/or otherwise decrease the efficacy of the photovoltaic cell.

What is needed is a system and method for producing an article having a surface modified by an energy source wherein the modified surface is substantially free of debris and is locally melted to increase resistance to crack propagation.

In an exemplary embodiment according to the present invention, a method for modifying a glass article for use with a photovoltaic cell includes providing a system, positioning one or more lasers in the system, and directing a predetermined energy provided by the system to a topographical feature on the surface of the article. In the embodiment, the system includes the one or more lasers positioned to direct the predetermined energy to the topographical feature on the surface of the article. Also, the predetermined energy modifies the surface of the topographical feature on the surface article.

In another exemplary embodiment, a modified article with increased resistance to crack propagation includes a topographical feature on a surface of the article. In the embodiment, the topographical feature has been modified by a predetermined energy directed from one or more lasers.

In another exemplary embodiment, a system for modifying an article to increase resistance to crack propagation includes one or more lasers positioned to direct a predetermined energy to a topographical feature on a surface of the article. In the embodiment, the predetermined energy modifies the topographical feature on the surface of the article by one or more of removing debris and repairing a defect, the repairing including local melting of the article to increase resistance to crack propagation.

Various aspects and embodiments of the present invention will now be described in connection with the accompanying drawings, in which:
FIG. 1 shows a thin film module mounted on a base according to the disclosure.
FIG. 2 is a diagram of a layer system making up cells of a module according to the disclosure.
FIG. 3 is a process flow diagram for an exemplary process for forming a module according to the disclosure.
FIG. 4 is an exemplary embodiment of a system according to the disclosure.
FIGS. 5-7 are exemplary embodiments of an article according to the disclosure.
FIG. 8 is a method of modifying a glass article according to the disclosure.

Wherever possible, the same reference numbers will be used throughout the drawings to represent the same parts.

Provided is a system and method for producing an article having a surface modified by an energy source wherein the modified surface is substantially free of debris and is locally melted to increase resistance to crack propagation. Embodiments of the present disclosure may result in articles having reduced or eliminated edge defects, articles having reduced or eliminated edge debris, articles having improved aesthetics, and/or cleaner articles. As used herein, the term "defect" refers to unintended physical and/or chemical structural differences in an article. As used herein, the term "debris" refers to particles and/or substances that may be unintentionally physically and/or chemically attached to the surface of an article.

In the disclosure, when a layer is being described as "adjacent," "on," or "over" another layer or substrate, it is to be understood that the layer can either be directly in contact or that another layer or feature can intervene.

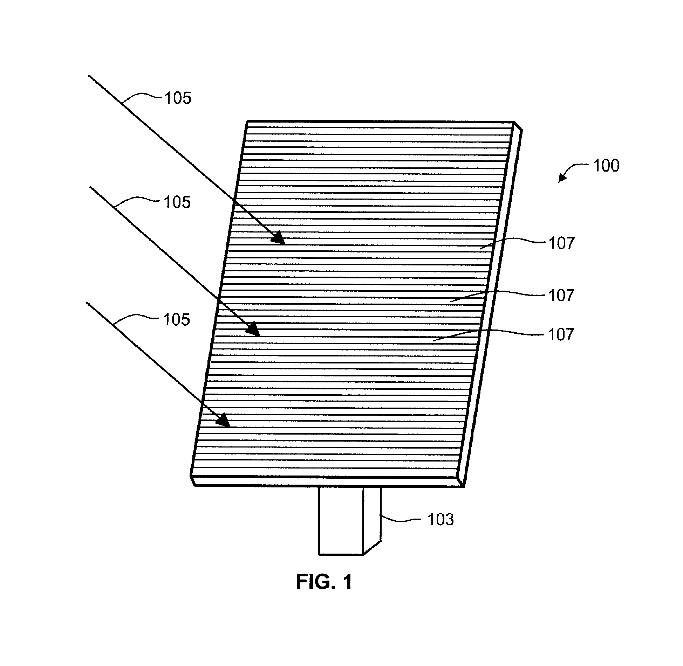

FIG. 1 shows a thin film PV module 100 mounted on a base 103. The PV module is arranged to receive light 105. The PV module is divided into a plurality of cells 107 that are arranged in series. Cells 107 are divided by spaces, non-conductive material and/or other structures separating circuits. For example, cells 107 may be isolated from each other by scribes formed by laser scribing. As light 105 shines on PV module 100, electricity is produced. The disclosure is not limited to the arrangement shown and may include other mounting arrangements and/or cells 107. One embodiment of the disclosure includes a thin film CdTe solar photovoltaic (PV) module. Such modules are used to produce solar electricity for numerous applications, for example, large ground-mounted systems and rooftop systems on commercial and residential buildings.

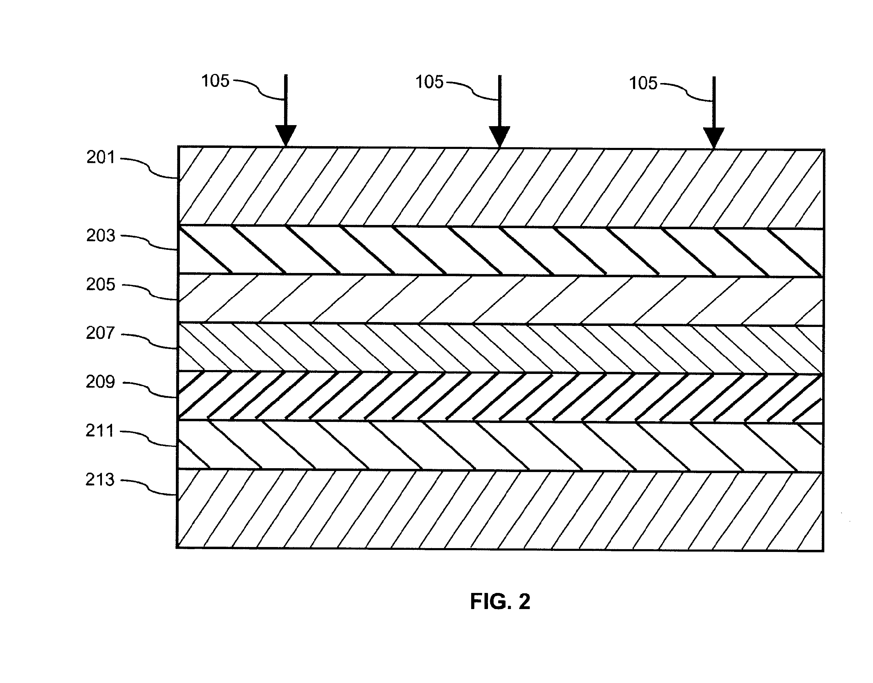

FIG. 2 is a diagram of the layer system making up cells 107 of PV module 100. The layers of cell 107 include a superstrate 201, a first conductive layer 203, a buffer layer 205, a first semiconductor layer 207, a second semiconductor layer 209, a second conductive layer 211 and an encapsulating glass 213. The layers of the cell 107 are arranged to generate and conduct electricity in a usable form when exposed to light 105.

Superstrate 201 is a sheet of high transmission glass onto which thin films are grown. Superstrate 201 receives light 105 (see e.g., FIG. 1) prior to the underlying layers. Superstrate 201 may be a high-transmission, low-iron float glass or any other suitable glass material having a high transmission rate for light. In another embodiment, superstrate 201 may also be a high transmission borosilicate glass.

After light 105 passes through superstrate 201, light 105 passes through first conductive layer 203. First conductive layer 203 may be a transparent conductive oxide (TCO), which permits transmission of light with little or no absorption. First conductive layer 203 is also electrically conductive, permitting electrical conduction to provide the series arrangement of cells. In one embodiment, the conductive layer is about 0.3 pm of stoichiometric cadmium stannate (nominally Cd₂SnO₄).

Other suitable conductive layers may include fluorine-doped tin oxide, aluminum-doped zinc oxide, and/or indium tin oxide. First conductive layer 203 may permit passage of light 105 through to the semiconductor layers (e.g., first semiconductor layer 207 and second semiconductor layer 209) while also functioning as an ohmic electrode to transport photogenerated charge carriers away from the light absorbing material.

A buffer layer 205 is adjacent to first conductive layer 203. Buffer layer 205 is more electrically resistive and protects the layers of cell 107 from chemical interactions from the glass and/or interactions might be incurred from subsequent processing. Inclusion of buffer layer 205 reduces or prevents electrical or other losses that may take place across cell 107 and across module 100. Suitable materials for buffer layer 205 may include zinc oxide containing materials and any other suitable barrier material having more electrical resistivity than first conductive layer 203 and capable of protecting the layers of the cell from interactions from the glass or interactions from subsequent processing. In addition, the inclusion of buffer layer 205 permits the formation of a first semiconductor layer 207 which permits photon passage while maintaining a high quality junction capable of generating electricity. In certain embodiments, buffer layer 205 may be omitted or substituted by another material or layer. In one embodiment, buffer layer 205 includes a combination of ZnO and SnO₂. For example, buffer layer 205 may be formed to a thickness of about 0.1 µm thick or less and may include ZnO and SnO₂ in about a one to two (1:2) stoichiometric ratio.

As shown in FIG. 2, first semiconductor layer 207 is adjacent to buffer layer 205 and receives light 105 subsequent to superstrate 201, first conductive layer 203 and buffer layer 205. First semiconductor layer 207 includes a wide bandgap n-type semiconductor material. Suitable semiconductor material for first semiconductor layer 207 includes, but is not limited to, CdS, SnO₂ CdO, ZnO, AnSe, GaN, In₂O₂, CdSnO, ZnS, CdZnS or other suitable n-type semiconductor material. In one embodiment, the first semiconductor layer 207 includes CdS. First semiconductor layer 207 may a have thickness from about 0.01 to about 0.1 µm. First semiconductor layer 207 may be formed by chemical bath deposition or by sputtering. First semiconductor layer 207 preferably has a smooth surface and is substantially uniform and free of impurities and pinholes.

First semiconductor layer 207 forms the junction with a second semiconductor layer 209 to create the photovoltaic effect in cell 107, allowing electricity to be generated from light 105. Second semiconductor layer 209 may include Cd, CdTe or other p-type semiconductor material, when provided with first semiconductor layer 207 provides a photovoltaic effect when exposed to light 105.

As shown in FIG. 2, second semiconductor layer 209 is adjacent first semiconductor layer 207. A second conductive layer 211 is adjacent second semiconductor layer 209 and provides an electrically conductive material that is capable of conducting electricity formed from the combination of first semiconductor layer 207 and second semiconductor layer 209 when exposed to light 105. Although FIG. 2 shows an arrangement of two layers for first semiconductor layer 207 and second semiconductor layer 209, any number of layers, including interstitial layers, may be utilized to provide the photovoltaic effect.

Second conductive layer 211 may be fabricated from any suitable conductive material and combinations thereof. For example, suitable materials include materials including, but not limited to, graphite, metallic silver, nickel, copper, aluminum, titanium, palladium, chrome, molybdenum alloys of metallic silver, nickel, copper, aluminum, titanium, palladium, chrome, and molybdenum and any combination thereof. In one embodiment, second conductive layer 211 may be a combination of graphite and nickel and aluminum alloys.

An encapsulating glass 213 may be adhered adjacent to second conductive layer 211. Encapsulating glass 213 may be a rigid structure suitable for use with the thin films of cell 107. Encapsulating glass 213 may be the same material as superstrate 201 or may be different. In addition, although not shown in FIG. 2, encapsulating glass 213 may include openings or structures to permit wiring and/or connection to cell 107.

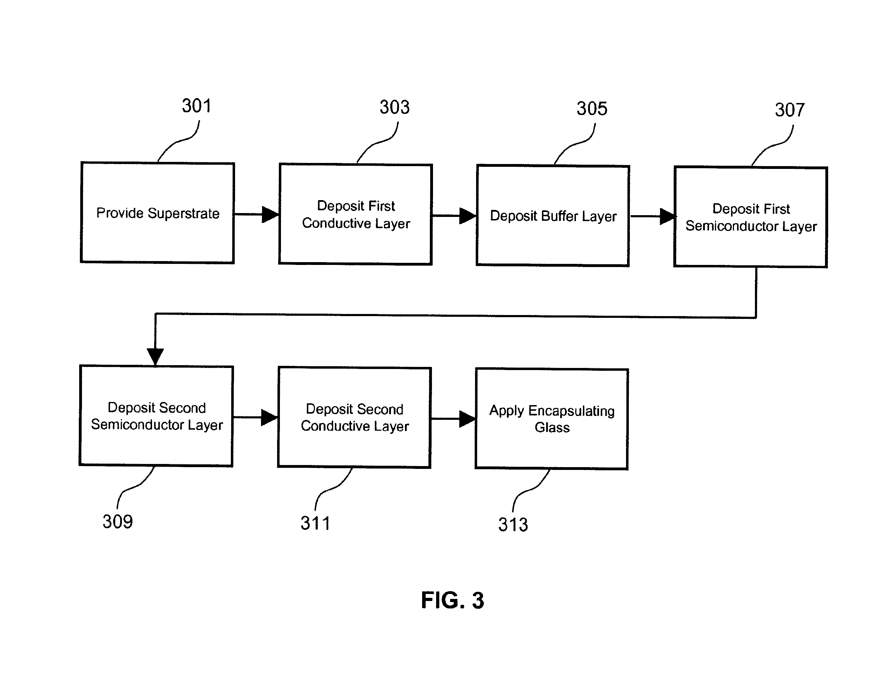

Module 100 and individual cells 107 may include other layers and structures not shown in FIG. 3. For example, superstrate 201 and/or encapsulating glass 213 may include a barrier coating or other structure to reduce or prevent diffusion of impurities into the layers. In addition, encapsulating glass 213 may include an adherent layer to adhere encapsulating glass 213 to the layers. Additional structures that may be present in module 100 and/or cells 107 include scribes, bussing structures, external wiring, and various conventional components useful with thin film and/or PV structures.

FIG. 3 shows a process flow diagram for an exemplary process for forming module 100. The process includes the formation of a thin film stack forming cell 107, wherein the films or layers are formed on superstrate 201 (shown from the top down in FIG. 2).

As shown in the flow diagram of FIG. 3, superstrate 201 is provided (box 301). Superstrate 201 may be fabricated from any suitable material capable of receiving thin films for use as photovoltaic cells and sufficiently transparent to allow transmission of light.

Subsequent to providing superstrate 201, first conductive layer 203 is deposited onto superstrate 201 (box 303). First conductive layer 203 is electrically conductive, which permits electrical conduction to provide the series arrangement of cells 107. In one embodiment, conductive layer 203 is about 0.3 µm of stoichiometric cadmium stannate (nominally Cd₂SnO₄). Other suitable conductive layers may include fluorine-doped tin oxide, aluminum-doped zinc oxide, or indium tin oxide. First conductive layer 203 can be formed, for example by direct current (DC) or radio refrequency (RF) sputtering. In one embodiment, first conductive layer 203 is a layer of substantially amorphous Cd₂SnO₄ that is sputtered onto superstrate 201. Such sputtering can be performed from a hot-pressed target containing stoichiometric amounts of SnO₂ and CdO onto superstrate 201 in a ratio of 1 to 2. The cadmium stannate can alternately be prepared using cadmium acetate and tin (II) chloride precursors by spray pyrolysis.

Once first conductive layer 203 is applied, buffer layer 205 may be applied to first conductive layer 203 (box 305). In one embodiment, buffer layer 205 may be formed, for example, by sputtering. In one example, buffer layer 205 may be formed by sputtering from a hot-pressed target containing stoichiometric amounts of about 67 mol % SnO₂ and about 33 mol % ZnO onto first conductive layer 203. As deposited by sputtering, the zinc tin oxide material for buffer layer 205 may be substantially amorphous. Layer 205 may have a thicknesses of between about 200 and 3,000 Angstroms, or between about 800 and 1,500 Angstroms, to have desirable mechanical, optical, and electrical properties. Buffer layer 205 may have a wide optical bandgap, for example about 3.3 eV or more, in order to permit the transmission of light.

First semiconductor layer 207 is deposited on buffer layer 205 (box 307). In one embodiment, first semiconductor layer 207 may be formed, for example, by chemical bath deposition or sputtering. First semiconductor layer 207 may be deposited to the thickness of from about 0.01 to 0.1 µm. One suitable material for use as first semiconductor layer 207 is CdS. A suitable thickness for a CdS layer may from about 500 and 800 Angstroms. First semidconductor layer 207 forms the junction with second semiconductor layer 209 to create the photovoltaic effect in cell 107, allowing it to generate electricity from light 105.

After the formation of first semiconductor layer 207, second semiconductor layer 209 is deposited on first semiconductor layer 207 (box 309). Second semiconductor layer 209 may include Cd, CdTe or other p-type semiconductor material. Second semiconductor layer 209 may be deposited by diffusive transport deposit, sputtering or other suitable deposition method for depositing p-type semiconductor thin film material.

Subsequent to the formation of second semiconductor layer 209, second conductive layer 211 is formed (box 311). Second conductive layer 211 may be fabricated from any suitable conductive material. Second conductive layer 211 may be formed by sputtering, electrodeposition, screen printing, physical vapor deposition (PVD), chemical vapor deposition (CVD) or spraying. In one embodiment, second conductive layer 211 is a combination of graphite that is screen printed onto the surface and nickel and aluminum alloy that is sputtered thereon.

All the sputtering steps described above are suitably magnetron sputtering at ambient temperature under highly pure atmospheres. However, other deposition processes may be used, including higher temperature sputtering, electrodeposition, screen printing, physical vapor deposition (PVD), chemical vapor deposition (CVD) or spraying. In addition, the processing may be provided in a continuous line or may be a series of batch operations. When the process is a continuous process, the sputtering or deposition chambers are individually isolated and brought to coating conditions during each coating cycle and repeated.

Once second conductive layer 211 is formed, encapsulating glass 213 is adhered to second conductive layer 211 (box 313). Encapsulating glass 213 may be a rigid material suitable for use with thin film structures and may be the same material or different material than superstrate 201. Encapsulating glass 213 may be adhered to second conductive layer 211 using any suitable method. For example, encapsulating glass 213 may be adhered to second conductive layer 211 using an adhesive or other bonding composition.

Although not shown in FIG. 3, other processing steps may be included in the process for forming module 100 and cells 107. For example, cleaning, etching, doping, dielectric or other selective insulative material deposition, formation of interstitial layers, scribing, heat treatments, and wiring may also be utilized. For example, wiring and/or bussing devices may be provided to complete the PV circuit (i.e. cells 107 in series arrangement) and to provide connectivity of the PV circuit to a load or other external device.

Scribing may be utilized to form the interconnections between the layers and isolate cells and/or layers of the thin film stack. Scribing may be accomplished using any known techniques for scribing and/or interconnecting the thin film layers. In one embodiment, scribing is accomplished using a laser directed at one or more layers from one or more directions. One or more laser scribes may be utilized to selectively remove thin film layers and to provide interconnectivity and/or isolation of cells 107. In one embodiment, the scribes and layer deposition are accomplished to interconnect and/or isolate cells 107 to provide a PV circuit having cells 107 in a series electrical arrangement.

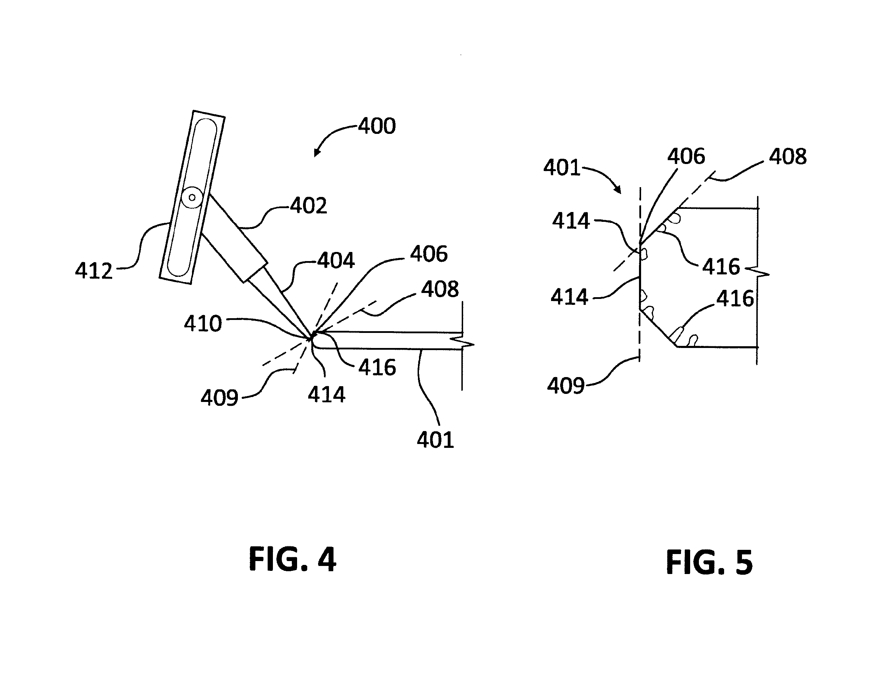

Referring to FIG. 4, an exemplary embodiment of an article 401 (for example, encapsulating glass 213 and/or superstrate 201) can be modified by a system 400. System 400 can include one or more lasers 402 positioned to direct a predetermined energy 404 to a topographical feature 406 having at least a first plane 408 and a second plane 409 of article 401, wherein first plane 408 is not coplanar with second plane 409. For example, system 400 may direct laser(s) 402 to a ridge, an edge, a corner, a groove, or any other suitable three-dimensional structure. System 400 may direct laser(s) 402 by having a broad region directing energy to first plane 408 and second plane 409 concurrently, and/or system 400 may direct laser(s) 402 by adjusting the position of laser(s) 402 toward a point in first plane 408 and a point in second plane 409.

Predetermined energy 404 provided by laser(s) 402 of system 400 modifies a surface 410 of article 401 by positioning laser(s) 402 and directing predetermined energy 404 to surface 410 of article 401. In one embodiment, the modification of surface 410 may be more pronounced at the shallowest portion of surface 410 and less pronounced at the deeper portions of surface 410. For example, directing predetermined energy 404 at surface 410 may modify all of surface 410 through a predetermined depth, may modify some of surface 410 through the predetermined depth, and/or may not affect portions below surface 410. A portion of surface 410 may be modified or substantially all of surface 410 may be modified. Modifying surface (for example, by cleaning and/or repairing) may occur at predetermined depths and/or predetermined frequency. Thus, areas to be cleaned (for example, debris 414) and/or areas to be repaired (for example, flaw(s) 416) may be partially or completely modified or removed.

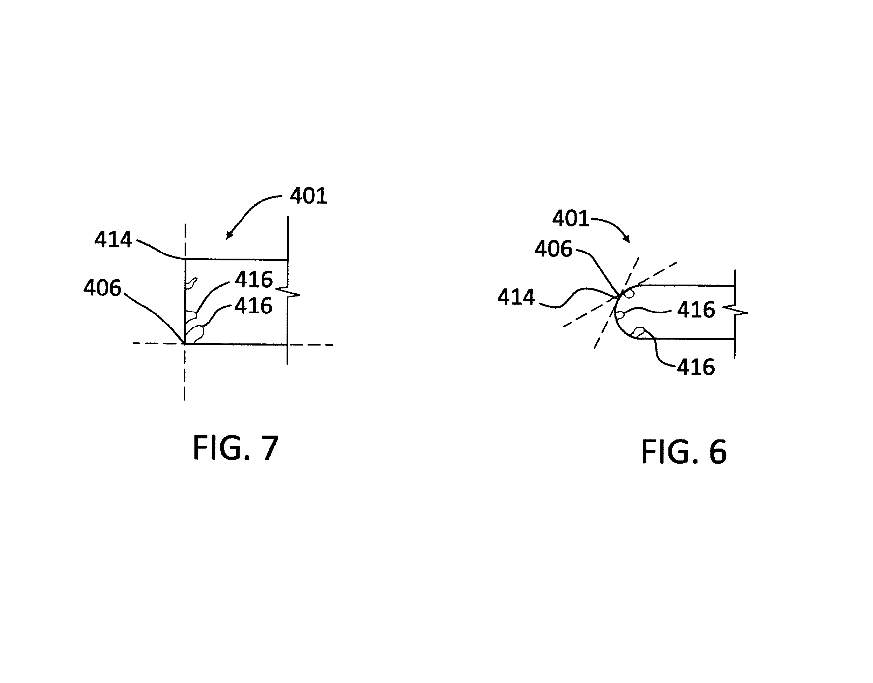

In an exemplary embodiment, predetermined energy 404 is directed to first plane 408 of article 401 and second plane 409 of article 401. In one embodiment, article 401 may include first plane 408 and second plane 409 in a seamed glass arrangement as shown in FIG. 5. In another embodiment, article 401 may include first plane 408 and second plane 409 in a pencil edged glass arrangement as shown in FIG. 6. In yet another embodiment, article 401 may include first plane 408 and second plane 409 in a square cut arrangement as shown in FIG. 7. Predetermined energy 404 may be provided to additional planes beyond first plane 408 and second plane 409.

Referring again to FIG. 4, laser(s) 402 may be any suitable laser or combination of lasers capable of providing predetermined energy 404. Predetermined energy 404 provided by laser(s) 402 may be selectively adjusted. The selective adjustment may be based upon adjusting the type of laser(s) 402, adjusting the intensity of laser(s) 402, adjusting the position of one laser 402 with respect to another laser 402, and/or adjusting the position of laser(s) 402 with respect to article 401. In an exemplary embodiment, system 400 may include a motion system 412 for selectively adjusting/maintaining the position of laser(s) 402 and/or article 401. For example, motion system 412 may adjust the position of laser(s) 402 and/or article 401. The adjustments may be linear or rotational. In one embodiment, a plurality of lasers 402 may selectively direct varying levels of predetermined energy 404 to surface 410 to modify surface 410.

Surface 410 (including first plane 408, second plane 409, and/or any suitable additional planes) of article 401 may be modified by being cleaned. Cleaning may remove debris 414 by vaporizing debris 414 and/or by causing debris 414 to no longer adhere to surface 410. Predetermined energy 404 provided by laser(s) 402 may be selectively adjusted for cleaning. The selective adjustment for cleaning may be based upon the type of debris 414, the type of bond between debris 414 and surface 410, the position/location of debris 414 on surface 410, the composition of surface 410, the geometry of surface 410, and/or other suitable properties relating to debris 414, laser(s) 402, and/or surface 410. Adjustment of laser(s) 402 may be based upon intensity and/or wavelength of predetermined energy 404.

Surface 410 (including first plane 408, second plane 409, and/or any suitable additional planes) of article 401 may be modified by being repaired. The repairing of one or more flaws 416 may include local melting of surface 410 of article 401. Repairing may include increasing the temperature of surface 410 to a predetermined level, for example, the melt temperature. Position of laser(s) 402 and/or article 401 may be adjusted based upon the depth, arrangement, and/or type of flaw(s) 416 in article 401. The depth of the increase of temperature of surface 410 of article 401 may be controlled by controlling laser(s) 402. The selective adjustment for repair may be based upon the type of flaw, the position/location of the flaw on surface 410, the composition of surface 410, the geometry of surface 410, and/or other suitable properties relating to the flaw, laser(s) 402 and/or surface 410.

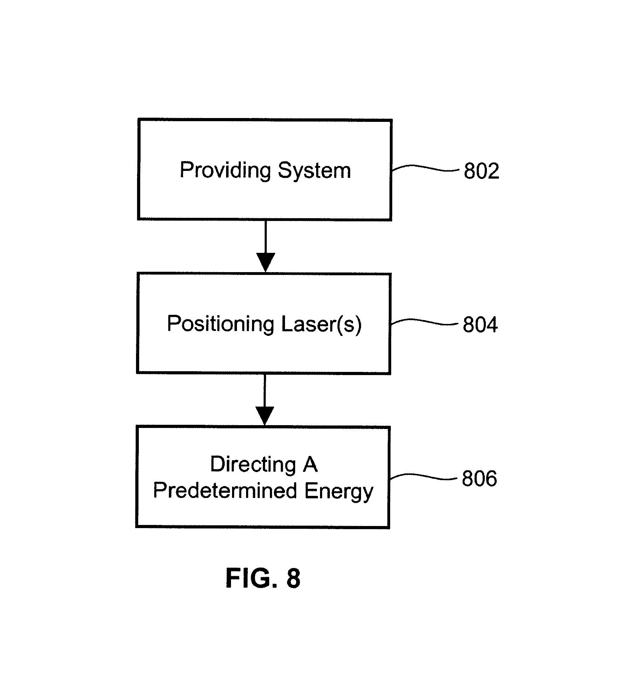

Referring to FIG. 8, in an exemplary embodiment, a method 800 for modifying a glass article for use with photovoltaic cell 107 includes providing a system (box 802), positioning laser(s) (box 804), and directing a predetermined energy (box 806) to topographical feature 406 on surface 410 of article 401. The system may be any suitable system for modifying a glass article to increase resistance to crack propagation. The laser(s) may be any suitable laser(s) capable of directing the predetermined energy.

While the disclosure has been described with reference to preferred embodiments, it will be understood by those skilled in the art that various adjustments may be made and equivalents may be substituted for elements thereof without departing from the scope of the disclosure. In addition, many modifications may be made to adapt a particular situation or material to the teachings of the disclosure without departing from the essential scope thereof. Therefore, it is intended that the disclosure not be limited to the particular embodiment disclosed as the best mode contemplated for carrying out this disclosure, but that the disclosure will include all embodiments falling within the scope of the appended claims.

Various aspects and embodiments of the present invention are defined by the following numbered clauses:
1. A method for modifying a glass article for use with a photovoltaic cell, the method comprising:
   providing a system, the system comprising:
      one or more lasers positioned to direct a predetermined energy to a topographical feature on a surface of the article; and
      wherein the predetermined energy modifies the surface of the topographical feature on the surface article;
      positioning the one or more lasers; and
      directing the predetermined energy to the topographical feature on the surface of the article.
2. The method of clause 1, wherein the topographical feature on the surface of the article is modified by removal of debris.
3. The method of any preceding clause, wherein the topographical feature on the surface of the article is modified by being repaired, the repairing includes local melting to increase resistance to crack propagation.
4. The method of any preceding clause, further comprising selectively maintaining one or more predetermined distances between the article and the one or more lasers.
5. The method of any preceding clause, wherein the article is a glass substrate for receiving thin film layers.
6. The method of any preceding clause, wherein the glass is an encapsulating glass of the photovoltaic cell.
7. The method of any preceding clause, wherein the photovoltaic cell includes a superstrate, a first conductive layer, a buffer layer, a first semiconductor layer, a second semiconductor layer, a second conductive layer, and an encapsulating glass.
8. The method of any preceding clause, wherein the glass is a superstrate having high-transmission, low-iron float glass or borosilicate glass.
9. The method of any preceding clause, wherein the topographic feature is selected from the group of three-dimensional structures consisting of a ridge, an edge, a corner, and a groove.
10. A modified article with increased resistance to crack propagation, the article comprising:
   a topographical feature on a surface of the article; and,
   wherein the topographical features has been modified by a predetermined energy directed from one or more lasers.
11. The article of any preceding clause, wherein the topographical feature on the surface of the article was modified by removal of debris.
12. The article of any preceding clause, wherein the topographical feature on the surface of the article was modified by being repaired.
13. The article of any preceding clause, wherein the repairing included local melting of the article to increase resistance to crack propagation.
14. The article of any preceding clause, wherein the article is a glass substrate for receiving thin film layers.
15. The article of claim 14, wherein the glass is an encapsulating glass of a photovoltaic cell.
16. The article of any preceding clause, wherein the photovoltaic cell includes a superstrate, a first conductive layer, a buffer layer, a first semiconductor layer, a second semiconductor layer, a second conductive layer, and an encapsulating glass.
17. The article of any preceding clause, wherein the glass is a superstrate having high-transmission, low-iron float glass or borosilicate glass.
18. The article of any preceding clause, wherein the topographic feature is selected from the group of three-dimensional structures consisting of a ridge, an edge, a corner, and a groove.
19. A system for modifying an article to increase resistance to crack propagation, the system comprising:
   one or more lasers positioned to direct a predetermined energy to a topographical feature on a surface of the article; and,
   wherein the predetermined energy modifies the topographical feature on the surface of the article; and,
   wherein the system modifies the topographical feature on the surface of the article by one or more of removing debris and repairing a defect, the repairing including local melting of the article to increase resistance to crack propagation.
20. The system of any preceding clause, further comprising a motion system for selectively maintaining one or more predetermined distances between the article and the one or more lasers.

## Claims

1. A method for modifying a glass article (401) for use with a photovoltaic cell, the method comprising:
providing a system (400), the system (400) comprising:
one or more lasers (402) positioned to direct a predetermined energy (404) to a topographical feature (406) on a surface of the article (401); and
wherein the predetermined energy (404) modifies the surface (410) of the topographical feature (406) on the surface article (401);
positioning the one or more lasers (402); and
directing the predetermined energy (404) to the topographical feature (406) on the surface (410) of the article (401).

2. The method of claim 1, wherein the topographical feature (406) on the surface (410) of the article (401) is modified by removal of debris (414).

3. The method of any preceding claim, wherein the topographical feature (406) on the surface (410) of the article (401) is modified by being repaired, the repairing includes local melting to increase resistance to crack propagation.

4. The method of any preceding claim, further comprising selectively maintaining one or more predetermined distances between the article (401) and the one or more lasers (402).

5. The method of any preceding claim, wherein the article (401) is a glass substrate for receiving thin film layers.

6. The method of claim 5, wherein the glass is an encapsulating glass (213) of the photovoltaic cell.

7. The method of any preceding claim, wherein the photovoltaic cell includes a superstrate (201), a first conductive layer (203), a buffer layer (205), a first semiconductor layer (207), a second semiconductor layer (209), a second conductive layer (211), and an encapsulating glass (213).

8. The method of any preceding claim, wherein the glass is a superstrate (201) having high-transmission, low-iron float glass or borosilicate glass.

9. The method of any preceding claim, wherein the topographic feature (406) is selected from the group of three-dimensional structures consisting of a ridge, an edge, a corner, and a groove.

10. The method of any preceding claim, wherein the topographic feature (406) is selected from the group of three-dimensional structures consisting of a ridge, an edge, a corner, and a groove.
